# EUROPÄISCHE PATENTANMELDUNG

(11) **EP 1 785 213 A2**
(43) Veröffentlichungstag der Anmeldung: **16.05.2007**
(21) Anmeldenummer: 06022573.7
(22) Anmeldetag: 28.10.2006
(51) Int. Cl.: B23K 20/10, B23K 101/40

(54) **Ultraschallschweißkopf**

(30) Priorität: 09.11.2005 DE 102005053400
(71) Anmelder: Semikron Elektronik GmbH & Co. KG Patentabteilung, 90431 Nürnberg (DE)
(72) Erfinder: Göbl, Christian, 90441 Nürnberg (DE); Augustin, Karlheinz, 90768 Fürth (DE)

(57) **Zusammenfassung**

Es wird ein Ultraschallschweißkopf (10) zur Ultraschallschweißverbindung eines Chips mit einem Substrat beschrieben, wobei die Schweißparameter eine vernachlässigbar kleine Streuung besitzen bzw. konstant sind. Das wird dadurch erreicht, dass am Schweißstempel (14) des Ultraschallschweißkopfes (10) ein die Haftreibung in Bezug zum zu verschweißenden Chip (22) erhöhendes Haftreibungselement (16) befestigt ist, das eine ebene Reibstirnfläche (20) besitzt. Das Haftreibungselement (16) ist vorzugsweise von einem Keramikplättchen (30) gebildet.

## Beschreibung

Die Erfindung betrifft einen Ultraschallschweißkopf zur Ultraschallschweißverbindung eines Chips mit einem Substrat.

Bekannte Ultraschallschweißköpfe weisen einen Schweißstempel mit einer Schweißstirnfläche auf. Die Schweißstirnfläche kann ebenflächig geschliffen ausgebildet sein. Eine andere Möglichkeit besteht darin, dass die Schweißstirnfläche pyramidenförmig eingedellt ausgebildet ist. Bei Schweißstempeln mit einer ebenflächigen geschliffenen Schweißstirnfläche sind Schleifspuren an der Metallisierung des jeweiligen Chips nach Durchführung der Ultraschallschweißung nicht zuverlässig vermeidbar. Schweißstempel mit einer pyramidenförmig eingedellten Schweißstirnfläche stellen lediglich zu den Chipkanten einen Formschluss her, so dass die Chipkanten entsprechend mechanisch belastet werden. Eine ungewollte Beschädigung des jeweiligen Chips durch die nicht flächige Betastung ist hierbei ebenfalls oftmals nicht vermeidbar.

Mit solchen bekannten Ultraschallschweißköpfen bzw. Schweißstempeln sind Streuungen der zu überwachenden Prozessparameter bei der Ultraschallschweißverbindung eines Chips mit einem Substrat nicht zu vermeiden.

In Kenntnis dieser Gegebenheiten liegt der Erfindung die Aufgabe zugrunde, solche Streuungen der Prozessparameter beim Ultraschallschweißen von Chips auf Substrate mit einfachen Mitteln zu verhindern.

Diese Aufgabe wird erfindungsgemäß durch die Merkmale des Anspruches 1, d.h. dadurch gelöst, dass am Schweißstempel des Schweißkopfes ein die Haftreibung in Bezug zum Chip erhöhendes Haftreibungselement befestigt ist, das eine ebene Reibstirnfläche besitzt. Dabei hat es sich als vorteilhaft erwiesen, wenn das Haftreibungselement von einem Keramikplättchen gebildet ist. Bei diesem Keramikplättchen kann es sich beispielsweise um ein Aluminiumoxid-Plättchen, um ein Siliziumkarbid-Plättchen o. dgl. handeln.

Erfindungsgemäß ist die ebene Reibstirnfläche des Keramikplättchens durch Läppen und anschließendes Aufrauhen hergestellt. Die Aufrauhung kann durch Ätzen hergestellt sein, sie kann eine Rauhtiefe von 5 bis 15 µm besitzen.

Der erfindungsgemäße Ultraschallschweißkopf weist den Vorteil auf, dass die Ultraschallenergie vom Ultraschallschweißkopf prozesssicher an den zu verschweißenden Chip übertragen wird. Diese Übertragung der Ultraschallenergie von der ebenen Reibstirnfläche des Schweißstempels der erfindungsgemäßen Ultraschallschweißkopfes an den Chip wird durch die Haftreibung zwischen der Reibstirnfläche des Schweißstempels und der entsprechenden Chipoberfläche bewirkt. Die Haftreibungskraft ist das Produkt aus der Normalkraft und dem Haftreibungskoeffizienten. Nachdem die Normalkraft durch den Chipaufbau und/oder die Gegenfläche begrenzt ist, bildet der Haftreibungskoeffizient die einzige variable Größe, die durch die Aufrauhung der ebenen Reibstirnfläche des Keramikplättchens bewirkt und wunschgemäß eingestellt wird, um die Normalkraft zu erhöhen.

Die Ultraschallenergie wird mit Hilfe des vorzugsweise von einem Keramikplättchen gebildeten Haftreibungselementes definiert in den zu verschweißenden Chip eingeleitet, wobei die Schweißparameter in vorteilhafter Weise eine vernachlässigbar kleine Streuung besitzen, d.h. quasi konstant sind.

Weitere Einzelheiten, Merkmale und Vorteile ergeben sich aus der nachfolgenden Beschreibung eines in der Zeichnung verdeutlichten Ausführungsbeispieles des erfindungsgemäßen Ultraschallschweißkopfes zum Ultraschallschweißen von Chips auf Substrate.

Es zeigen.
- Figur 1: eine Seitenansicht des Ultraschallschweißkopfes mit einem zu verschweißenden Chip, und
- Figur 2: eine Ansicht des von einem Keramikplättchen gebildeten Haftreibungselementes des Ultraschallschweißkopfes in Blickrichtung der Pfeile II-II in Figur 1.

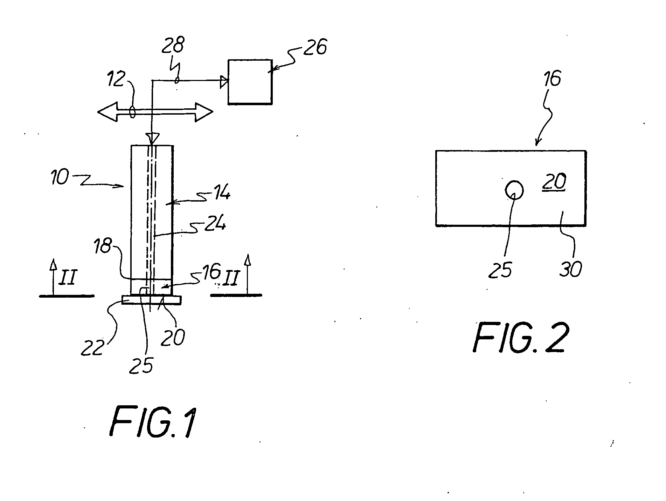

Figur 1 zeigt einen Ultraschallschweißkopf 10, der in an sich bekannter Weise in Ultraschallschwingungen versetzt wird. Diese sind durch den Doppelpfeil 12 schematisch angedeutet. Der Ultraschallschweißkopf 10 weist einen Schweißstempel 14 auf, an dem ein Haftreibungselement 16 befestigt ist. Diese Befestigung erfolgt mittels eines geeigneten Klebers 18. Vor dem Festkleben des Haftreibungselementes 16 am Schweißstempel 14 wird das Haftreibungselement 16 an seiner vom Schweißstempel 14 abgewandten Reibstirnfläche 20 zuerst geläppt und anschließend aufgerauht. Diese Aufrauhung erfolgt vorzugsweise durch Ätzen. Die Rauhtiefe der Aufrauhung der Reibstirnfläche 20 des Haftreibungselementes 16 beträgt beispielsweise 5 bis 15 µm.

Zum Ansaugen eines an einer Schaltung festzuschweißenden Chips 22 am Ultraschallschweißkopf 10 bzw. an der Reibstirnfläche 20 des Haftreibungselementes 16 erstreckt sich durch den Schweißstempel 14 ein Durchgangsloch 24, das mit einem Durchgangsloch 26 axial fluchtet, das im Haftreibungselement 16 ausgebildet ist.

Der Ultraschallschweißkopf 10 ist mit einer Vakuumquelle 26 verbindbar bzw. verbunden, die in Figur 1 durch einen Block schematisch verdeutlicht ist. Die Verbindung der Vakuumquelle 26 mit dem Ultraschallschweißkopf 10 ist durch den abgewinkelten Pfeil 28 angedeutet.

Das Haftreibungselement 16 ist von einem Keramikplättchen 30 gebildet, das beispielsweise eine rechteckige Grundflächengestalt besitzt, wie aus Figur 2 ersichtlich ist. Mit der Bezugsziffer 24 ist auch in Figur 2 das im Keramikplättchen 30 ausgebildete Durchgangsloch bezeichnet.

Das Keramikplättchen 30 besteht aus einer verschleißfesten Keramik und die Reibstirnfläche 20 des Keramikplättchens 30 besitzt eine definierte Oberflächenrauhigkeit, d.h. Aufrauhung, die vorzugsweise durch Ätzen hergestellt wird.

Die Ultraschallenergie des Ultraschallschweißkopfes 10 wird über die ebene Reibstirnfläche 20 des Keramikplättchens 30 des Haftreibungselementes 16 in den zu verschweißenden Chip 22 eingeleitet. Die Schweißparameter sind in vorteilhafter Weise quasi konstant.

### Bezugsziffernliste:

- 10: Ultraschallschweißkopf (für 22)
- 12: Ultraschallschwingung/Doppelpfeil (von 10)
- 14: Schweißstempel (von 10)
- 16: Haftreibungselement (an 14)
- 18: Kleber (zwischen 16 und 14)
- 20: ebene Reibstirnfläche (von 16)
- 22: zu verschweißender Chip
- 24: Durchgangsloch (in 14)
- 25: Durchgangsloch (in 16)
- 26: Vakuumquelle (für 10)
- 28: fluidische Verbindung / Doppelpfeil (zwischen 26 und 10)
- 30: Keramikplättchen (von 16)

## Patentansprüche

1. Ultraschallschweißkopf zur Ultraschallschweißverbindung eines Chips mit einem Substrat
**dadurch gekennzeichnet,**
**dass** am Schweißstempel (14) des Ultraschallschweißkopfes (10) ein die Haftreibung in Bezug zum zu verschweißenden Chip (22) erhöhendes Haftreibungselement (16) befestigt ist, das eine ebene Reibstirnfläche (20) besitzt.

2. Ultraschallschweißkopf nach Anspruch 1,
**dadurch gekennzeichnet,**
**dass** das Haftreibungselement (6) von einem Keramikplättchen (30) gebildet ist.

3. Ultraschallschweißkopf nach Anspruch 2
**dadurch gekennzeichnet,**
**dass** die ebene Reibstirnfläche (20) des Keramikplättchens (30) durch Läppen und anschließendes Aufrauhen hergestellt ist.

4. Ultraschallschweißkopf nach Anspruch 3
**dadurch gekennzeichnet,**
**dass** die Aufrauhung durch Ätzen hergestellt ist.

5. Ultraschallschweißkopf nach Anspruch 3 oder 4,
**dadurch gekennzeichnet,**
**dass** die Aufrauhung eine Rauhtiefe von 5 bis 15 µm besitzt.
